# EUROPÄISCHE PATENTSCHRIFT

(11) **EP 2 230 176 B1**
(45) Veröffentlichungstag und Bekanntmachung des Hinweises auf die Patenterteilung: **22.06.2016**
(21) Anmeldenummer: 10156102.5
(22) Anmeldetag: 10.03.2010
(51) Int. Cl.: B64C 27/72, H01L 41/083

(54) **Rotorblattanordnung mit einem Rotorblattaktuator für einen Helikopter**
Rotor blade assembly with a rotor blade actuator for a helicopter
Agencement de pale de rotor avec un actionneur de pale de rotor pour un hélicoptère

(30) Priorität: 13.03.2009 DE 102009012798
(43) Veröffentlichungstag der Anmeldung: 22.09.2010
(73) Patentinhaber: Airbus Defence and Space GmbH, 85521 Ottobrunn (DE)
(72) Erfinder: Grohmann, Boris, 82024 Taufkirchen (DE); Storm, Stefan, 85716 Unterschleißheim (DE)
(74) Vertreter: Isarpatent

(56) Entgegenhaltungen:
- EP-A1- 0 977 284
- WO-A1-2008/068472
- DE-A1- 10 326 366
- DE-A1-102005 061 752
- US-A1- 2006 214 065
- US-A1- 2008 075 930

## Beschreibung

### Gebiet der Erfindung

Die vorliegende Erfindung betrifft ein Rotorblatt mit einem Rotorblattaktuator sowie eine Rotorblattaktuatoranordnung, und insbesondere einen Rotorblattaktuator mit einer multifunktionalen Geometrie zur Bereitstellung einer Vielzahl unterschiedlicher Rotorblattaktuatoranordnungen.

### Hintergrund der Erfindung

Bei Helikopterrotoren führt eine Interaktion von Blattspitzenwirbeln mit nachlaufenden Blättern zu einer Lärmentwicklung. Ferner führen hohe Mach-Zahlen im schnellen Vorwärtsflug an der Blattspitze zu einer Lärmentwicklung aufgrund hoher Geschwindigkeiten, insbesondere da die Spitzen eines Rotorblattes bei einem schnellen Vorwärtsflug Geschwindigkeiten relativ zu der Umgebungsluft in der Größenordnung der Schallgeschwindigkeit annehmen können. Im Allgemeinen sind Rotorblätter im Vorwärtsflug starken Vibrationen ausgesetzt, die sowohl zu einer Materialbeanspruchung als auch zu einer erhöhten Geräuschentwicklung beitragen.

Die DE 103 26 366 A1 beschreibt eine zellulare Aktuatoreinrichtung mit einer Vielzahl von als Kammern ausgebildeten Elementarzellen, welche ein Druckmedium enthalten. Die US 2008/075930 A1 beschreibt einen mechanischen Aktuator. Die EP 0 977 284 A1 beschreibt einen Vielschicht-Piezoaktuator. Die WO 2008/068472 A1 beschreibt ein Tragflächenglied mit einer flexiblen Oberfläche. Die DE 10 2005 061 752 A1 beschreibt ein dreidimensionales Stapelpiezoelement und einen piezoelektrischen Aktuator mit einem entsprechenden Stapelpiezoelement.

Die US 2006/124065A1 beschreibt ein verformbares aerodynamisches Flügelprofil wobei rechteckige Piezoktuatoren auf und in dem Flügelprofil verwendet werden, welche bei Flugzeugflügel, Hubschrauberrotorblätter oder Triebwerksschaufel angewendet werden können.

Aus dem Stand der Technik sind beispielsweise Rotorblattspitzen bekannt, die mittels einer diskreten Klappe die Blattspitzenwirbel beeinflussen können, so wie beispielsweise in US 6,461,106 B1 beschrieben ist. Ferner ist aus dem Stand der Technik bekannt, die Blattspitzen gepfeilt auszugestalten, um aufgrund der besonderen Geometrie eine Optimierung der Flugeigenschaften vornehmen zu können.

### Zusammenfassung der Erfindung

Vor dem Hintergrund der oben genannten Probleme kann es als eine Aufgabe der vorliegenden Erfindung betrachtet werden, einen Rotorblattaktuator bzw. eine Rotorblattaktuatoranordnung bereitzustellen, die eine Reduktion von Geräuschentwicklung und Vibration bei Helikoptern ermöglicht, um auf diese Weise eine Steigerung der aerodynamischen Effizienz herbeizuführen.

Die Aufgabe der vorliegenden Erfindung wird gelöst durch den Gegenstand der unabhängigen Ansprüche, wobei beispielhafte Ausgestaltungen durch die abhängigen Ansprüche verkörpert werden.

Gemäß einer beispielhaften Ausführungsform der Erfindung wird ein Rotorblatt mit einem Rotorblattaktuator bereitgestellt mit einer Aktuatoroberfläche, die ausgelegt ist zum Applizieren auf einer Oberfläche des Rotorblattes bzw. der Rotorblattspitze, und einer ansteuerbaren aktiven ersten Schicht, die parallel zu der Aktuatoroberfläche angeordnet ist, wobei die erste Schicht eine Ansteuerbarkeit aufweist, die bei einer Ansteuerung eine Längenänderung in eine erste Richtung entlang der Aktuatoroberfläche hervorruft, wobei die Umfangskontour des Rotorblattaktuators einem gleichmäßigen Sechseck oder einer Gleichteilung davon entspricht, wobei der Rotorblattaktuator ausgelegt ist, in einem applizierten Zustand durch die Längenänderung eine Verformung der Oberfläche des Rotorblattes bzw. der Rotorblattspitze hervorzurufen.

Auf diese Weise kann das Profil des Rotorblattes variiert werden, wodurch sich beispielsweise ein Luftwiderstand reduzieren lässt, sodass auf diese Weise eine Lärm- und Vibrationsentwicklung vermindert werden kann und sich eine Steigerung der aerodynamischen Effizienz einstellt. Mittels der Aktuatoroberfläche kann der entsprechend vorbereitete Aktuator auf einer Oberfläche eines Rotorblattes bzw. einer Rotorblattspitze appliziert werden, beispielsweise auf der Rotorblattdecke. Dabei kann der Aktuator sowohl auf der Außenseite des Rotorblattes als auch auf der Innenseite des Rotorblattes angeordnet sein. Bei einer Anordnung des Aktuators im Inneren des Blattes, zum Beispiel in der Symmetrieebene oder in der Profilsehne, können die Einflüsse der Umgebung auf die Aktuatoranordnung vermindert werden, da sich der Aktuator im Inneren des Rotors befindet. Durch eine aktive erste Schicht, die eine Längenänderung entlang der Aktuatoroberfläche hervorrufen kann, kann ein Biegemoment auf der Rotorblattoberfläche hervorgerufen werden, das die Rotorblattoberfläche verformt. Mittels einer derartigen Verformung kann bei einer entsprechend schnellen Steuerung bzw. Regelung einer Vibrations- und Geräuschentwicklung entgegengewirkt werden, so dass das Material der Rotorblätter weniger beansprucht wird und auf diese Weise ein effizienterer Flugbetrieb möglich wird. Die Aktuatoren können beispielsweise als Piezoaktuatoren ausgeführt sein. Vorzugsweise wird dabei der d33-Effekt in der ersten Richtung ausgenutzt. Die Aktuatoren können als sogenannte Stack-Aktuatoren oder mit interdigitalen Elektroden (interdigitated electrodes, IDE) ausgeführt sein. Die Umfangskontour in Form eines gleichmäßigen Sechseckes erlaubt ein lückenloses Aneinandersetzen der Rotorblattaktuatoren, wobei jedoch die aneinandergrenzenden Rotorblattaktuatoren unterschiedliche Längenänderungsrichtungen aufweisen können. Insbesondere können Übergänge zwischen längs und quer Längenänderungen lückenlos vorgenommen werden. Eine Umfangskontour in Form einer Gleichteilung eines gleichmäßigen Sechseckes erlaubt die modulare Zusammensetzung zu einem Sechseck. Unter einem gleichmäßigen Sechseck ist hier ein Sechseck mit sechs gleichlangen Seiten und sechs gleichen Winkeln zu verstehen. Dies entspricht im Wesentlichen einer Wabenform. Unter einer Gleichteilung ist dabei jede Teilung in Teile zu verstehen, die wiederum eine gleiche Umfangskontur aufweisen und zusammengesetzt wieder ein gleichmäßiges Sechseck ergeben. Insbesondere können dies gleichseitige Teile sein, wie beispielsweise gleichseitige Dreiecke oder gleichseitige Rauten mit Innenwinkel von im Wesentlichen 60° und 120°. Es können jedoch auch gleichseitige Dreiecke vorgesehen sein mit einem Innenwinkel von 30° und 120°, was im Wesentlichen einer längshalbierten Raute entspricht.

Gemäß einer beispielhaften Ausführungsform der Erfindung, wird ein Rotorblattaktuator bereitgestellt mit einer Aktuatoroberfläche, die ausgelegt ist zum Applizieren auf einer Oberfläche eines Rotorblattes bzw. einer Rotorblattspitze, und einer ansteuerbaren aktiven ersten Schicht, die parallel zu der Aktuatoroberfläche angeordnet ist, wobei die erste Schicht eine Ansteuerbarkeit aufweist, die bei einer Ansteuerung eine Längenänderung in eine erste Richtung entlang der Aktuatoroberfläche hervorruft, wobei die Umfangskontour des Rotorblattaktuators anstatt einem gleichmäßigen Sechseck oder einer Gleichteilung davon einem gleichschenkligen Dreieck entspricht, wobei der Rotorblattaktuator ausgelegt ist, in einem applizierten Zustand durch die Längenänderung eine Verformung der Oberfläche des Rotorblattes bzw. einer Rotorblattspitze hervorzurufen.

Das gleichschenklige Dreieck kann dabei ein rechtwinkliges Dreieck sein.

Gemäß einer beispielhaften Ausführungsform der Erfindung weist die Rotorblattanordnung ferner eine ansteuerbare zweite Schicht auf, die über der ansteuerbaren ersten Schicht angeordnet ist, wobei die zweite Schicht eine Ansteuerbarkeit aufweist, die bei einer Ansteuerung eine Längenänderung in eine zweite Richtung entlang der Aktuatoroberfläche hervorruft, wobei die erste Schicht und die zweite Schicht derart miteinander gekoppelt sind, dass der Rotorblattaktuator bei einer Längenänderung in eine erste Richtung und eine davon verschiedene Längenänderung in eine zweite Richtung eine veränderte Krümmung der Aktuatoroberfläche aufweist.

Auf diese Weise kann ein Rotorblattaktuator bereitgestellt werden, der aufgrund des zweischichtigen Aufbaus bereits in sich eine Verformung bzw. Flächenkrümmung hervorrufen kann, ähnlich eines Bimetall, so dass auch hochelastische Oberflächen bzw. hochelastische Schichten einer Verformung unterworfen werden können. Insbesondere kann ein derartiger Aktuator bereits vor der eigentlichen Applizierung auf ein Rotorblatt separat gefertigt werden, was eine wesentlich höhere Fertigungsqualität ermöglicht. Zwischen der aktiven ersten Schicht und der aktiven zweiten Schicht kann beispielsweise auch eine dritte passive Schicht angeordnet sein, auf die die erste und zweite Schicht appliziert werden können, so dass die mittlere passive Schicht beispielsweise als ein Substrat bzw. Träger dienen kann.

Gemäß einer beispielhaften Ausführungsform der Erfindung sind die erste Richtung und die zweite Richtung voneinander verschieden.

Auf diese Weise kann eine Torsion der Fläche hervorgerufen werden, die neben der Flächenkrümmung in eine Richtung auch eine dreidimensionale Verformung der Rotorblattoberfläche erlaubt.

Gemäß einer beispielhaften Ausführungsform der Erfindung sind die erste Richtung und die zweite Richtung antiparallel zueinander.

Auf diese Weise kann erreicht werden, dass bei einer gleichartigen Ansteuerung der ersten aktiven Schicht und der zweiten aktiven Schicht die Längenänderung zueinander entgegengesetzt sind. Mit anderen Worten wird bei einer gleichartigen Ansteuerung auf diese Weise bei der einen Schicht eine Längenausdehnung hervorgerufen, während bei der anderen Schicht eine Längenkontraktion hervorgerufen wird. Auf diese Weise kann der Krümmungseffekt verstärkt werden, wodurch sich insbesondere die Auslenkung der Krümmung bei einer Ansteuerung verstärkt. Dies kann beispielsweise erreicht werden durch Piezoaktuatoren, die in den unterschiedlichen Achsen der Piezokristalle angesteuert werden bzw. entgegengesetzt orientiert angeordnet sind.

Gemäß einer beispielhaften Ausführungsform der Erfindung sind die erste Richtung und die zweite Richtung orthogonsal zueinander.

Auf diese Weise kann eine verstärkte Torsion bzw. dreidimensionale Verwölbung hervorgerufen werden, dadurch dass sich die Verformung der ersten Aktuatorschicht in die eine Richtung und die Verformung der zweiten Aktuatorschicht in die orthogonale Richtung überlagern. Auf diese Weise kann die Schubverformung verstärkt werden.

Gemäß einer beispielhaften Ausführungsform der Erfindung weist der Rotorblattaktuator eine Umfangskontur bezogen auf seine flächige Ausgestaltung auf, die im Wesentlichen einem gleichseitigen Dreieck entspricht.

Ein gleichseitiges Dreieck erlaubt eine hochvariable Anordnung mehrerer Rotorblattaktuatoren und eine Kombination zu einer unterschiedlichen Gesamtgeometrie einer Rotorblattaktuatoranordnung, wobei durch ein Zusammensetzen mehrerer gleichseitiger Dreiecke unterschiedliche Formen einer Aktuatoranordnung bereitgestellt werden können.

Gemäß einer beispielhaften Ausführungsform der Erfindung weist der Rotorblattaktuator eine zweipolige Kontaktierung mit einem ersten Kontaktpol und einem zweiten Kontaktpol auf, wobei der erste Kontaktpol eine Kontaktfläche an einer ersten Seite des Dreiecks aufweist und der zweite Kontaktpol eine Kontaktfläche an einer zu der ersten Seite benachbarten zweiten Seite des Dreiecks aufweist.

Aufgrund der seitenflächigen Kontaktfläche können Rotorblattaktuatoren aneinandergelegt werden und auf diese Weise eine Durchkontaktierung erreicht werden, so dass eine Zuleitung zu jedem einzelnen Aktuator entbehrlich ist. Außerdem können aus im wesentlichen gleichen Dreiecksaktuatoren Aktuatoranordnungen mit unterschiedlichen Charakteristiken zusammengesetzt werden. Die Rotorblattaktuatoren können für die Ansteuerung sowohl parallel als auch in Reihe geschaltet werden. Je nach Zusammensetzung einer Rotorblattaktuatoranordnung aus einer Mehrzahl von Rotorblattaktuatoren in Dreiecksform kann eine unterschiedliche Verformungscharakteristik der Rotorblattaktuatoranordnung erreicht werden. Die Kontaktfläche kann dabei sowohl die gesamte Seitenkante des Dreiecks umfassen, jedoch auch nur Teile der Seitenkante. Ebenso kann neben der Kontaktierung für den ersten Pol auf einer Dreiecksseite auch eine weitere Kontaktierung des Gegenpols vorgesehen sein, so dass beispielsweise zwei benachbarte Dreiecksseiten jeweils eine Kontaktierung des ersten Pols als auch eine Kontaktierung des zweiten Pols aufweisen, so dass eine variable Kontaktierung der einzelnen Rotorblattaktuatoren erfolgen kann.

Gemäß einer beispielhaften Ausführungsform der Erfindung weist der Rotorblattaktuator eine Umfangskontur bezogen auf seine flächige Ausgestaltung auf, die im Wesentlichen einem regelmäßigen Polygon entspricht.

Gemäß einer beispielhaften Ausführungsform der Erfindung weist die Rotorblattaktuatoranordnung eine Umfangskontur bezogen auf eine fläche Ausgestaltung der Rotorblattaktuatoranordnung auf, die im Wesentlichen einem gleichseitigen Sechseck entspricht.

Dabei ist beispielsweise die Form eines regelmäßigen sechseckigen Polygons in Form einer Wabe geeignet, um eine Mehrzahl von Rotorblattaktuatoren in einer Polygonform flächendeckend aneinanderzusetzen, ohne dass Zwischenräume verbleiben. Jedoch können die Rotorblattaktuatoren auch eine Umfangskontur in Form eines gleichmäßigen fünfeckigen Polygons oder eines Quadrates aufweisen, so dass eine lückenfreie Verlegung der Rotorblattaktuatoren in einer Rotorblattaktuatoranordnung entsteht.

Gemäß einer beispielhaften Ausführungsform der Erfindung weist eine Rotorblattaktuatoranordnung sechs Rotorblattaktuatoren auf, von denen jeder eine flächige Ausgestaltung aufweist, die im Wesentlichen einem gleichseitigen Dreieck entspricht.

Auf diese Weise kann eine lückenlose Belegung einer Rotorblattoberfläche mit Rotorblattaktuatoren erfolgen.

Gemäß einer beispielhaften Ausführungsform der Erfindung weist die sechseckige Rotorblattaktuatoranordnung bzw. der Rotorblattaktuator eine zweipolige Kontaktierung mit einem ersten Kontaktpol und einem zweiten Kontaktpol auf, wobei der erste Kontaktpol jeweils eine Kontaktfläche an einer ersten Seite und an einer der ersten Seite benachbarten zweiten Seite des Sechsecks aufweist und der zweite Kontaktpol jeweils eine Kontaktfläche an einer der ersten Seite gegenüberliegenden vierten Seite und an einer der zweiten Seite gegenüberliegenden fünften Seite des Sechsecks aufweist.

Auf diese Weise ist eine Anordnung mehrerer Rotorblattaktuatoren oder Rotorblattaktuatoranordnungen möglich, die bei einer entsprechenden benachbarten Positionierung keine separate Zuleitung für jeden Rotorblattaktuator erfordert, sondern durch eine entsprechende Durchkontaktierung bzw. Durchschleifung der Kontakte eine Kontaktierung jedes einzelnen Rotorblattaktuators bereitstellt.

Gemäß einer beispielhaften Ausführungsform der Erfindung weist die Rotorblattaktuatoranordnung bzw. der Rotorblattaktuator eine zweipolige Kontaktierung mit einem ersten Kontaktpol und einem zweiten Kontaktpol auf, wobei der erste Kontaktpol jeweils eine Kontaktfläche an einer ersten Seite und an einer der ersten Seite gegenüberliegenden vierten Seite des Sechsecks aufweist und der zweite Kontaktpol jeweils eine Kontaktfläche an einer der ersten Seite benachbarten Seite und an einer der zweiten Seite gegenüberliegenden fünften Seite des Sechsecks aufweist.

Auf diese Weise kann ebenfalls eine Durchkontaktierung erreicht werden, die eine separate Zuleitung der Ansteuerleitungen zu jedem der Rotorblattaktuatoranordnungen bzw. Rotorblattaktuatoren entbehrlich macht.

Durch eine Kombination der beiden zuvor genannten Ausführungsformen mit den entsprechenden Kontaktpolanordnungen kann eine Gesamtanordnung von sechseckigen Rotorblattaktuatoren bzw. Rotorblattaktuatoranordnungen erreicht werden, die im Wesentlichen bezüglich der Kontakte konfliktfrei zu benachbarten Aktuatorbereichen verlegt werden kann. Mit anderen Worten können zwei Aktuatorbereiche mit unterschiedlicher Aktuatorcharakteristik, beispielsweise einem Torsionsbereich und einem reinen Biegebereich aneinandergrenzend angeordnet werden, ohne dass ein Konflikt bei der Kontaktierung auftritt oder eine separate Isolierung zwischen den Kontaktseiten der Sechsecke vorgesehen sein muss.

Gemäß einer beispielhaften Ausführungsform der Erfindung weist die Rotorblattaktuatoranordnung bzw. der Rotorblattaktuator eine zweipolige Kontaktierung mit einem ersten Kontaktpol und einem zweiten Kontaktpol auf, wobei sowohl der erste Kontaktpol als auch der zweite Kontaktpol jeweils eine Kontaktfläche an wenigstens einer ersten Seite und einer zweiten Seite des gleichmäßigen Polygons aufweisen und die Kontaktfläche des ersten Kontaktpols und die Kontaktfläche des zweiten Kontaktpols an der ersten Seite derart angeordnet sind, dass sie bezüglich einer Position und Polarität mit der Kontaktfläche des ersten Kontaktpols und der Kontaktfläche des zweiten Kontaktpols an der zweiten Seite derart korrespondieren, dass bei einem benachbarten Positionieren der ersten Seite und einer zweiten Seite einer benachbarten Rotorblattaktuatoranordnung bzw. eines benachbarten Rotorblattaktuators eine benachbarte Position korrespondierender Kontaktflächen erreicht wird.

Auf diese Weise kann bereits bei einer benachbarten Positionierung zweier Rotorblattaktuatoranordnungen bzw. Rotorblattaktuatoren eine vollständige Kontaktierung des benachbarten Rotorblattaktuators bzw. Rotorblattaktuatorenanordnung erreicht werden, insbesondere da auf jeder bzw. jeder relevanten Seite des sechseckigen Rotorblattaktuators bzw. Rotorblattaktuatoranordnung eine entsprechende Anzahl von Kontakten entsprechend der Anzahl der Kontaktpole vorgesehen ist.

Gemäß einer beispielhaften Ausführungsform der Erfindung sind die Kontaktflächen an einer bezüglich der Umfangskontur nach außen gerichteten Kante angeordnet.

Auf diese Weise bedarf es keiner zusätzlichen Leitungen bzw. Leiterbahnen, auf die die Rotorblattaktuatoren bzw. die Rotorblattaktuatoranordnungen aufgebracht werden, so dass eine Kontaktierung direkt durch ein Angrenzen der Rotorblattaktuatoren erreicht werden kann. Gegebenenfalls ist eine Verklebung mit einem leitfähigen Klebstoff bzw. ein Ausfugen mit einem hinreichend leitfähigen Fugenmaterial notwendig, um eine zuverlässige Kontaktierung auch im Betrieb zu erreichen.

Gemäß einer beispielhaften Ausführungsform der Erfindung ist auf einer Seite des Sechsecks eine symmetrische Anordnung der Kontakte derart angeordnet, dass der Aktuator auch bei einer "upside down" Applizierung mit korrespondierenden Kontakten eines benachbarten Aktuators kontaktiert werden kann. Dies kann beispielsweise mit einer Anordnung von drei Kontakten auf einer Seite erreicht werden, wobei ein Kontakt einem ersten Kontaktpol zugeordnet ist und mittig an der Seite angeordnet ist und die beiden anderen Kontakte dem zweiten Kontaktpol zugeordnet sind und jeweils in gleichem Abstand seitlich vom ersten Kontakt angeordnet sind. Auf diese Weise ist es unerheblich, welche Seite des Aktuators, oben oder unten, auf der Rotorblattdecke appliziert wird.

Gemäß einer beispielhaften Ausführungsform der Erfindung wird eine Rotorblattaktuatorstruktur vorgeschlagen mit einer Vielzahl von Rotorblattaktuatoren, wobei die Vielzahl von Rotorblattaktuatoren in einer Rotorblattaktuatoranordnung in einer Wabenstruktur angeordnet ist.

Gemäß einer beispielhaften Ausführungsform der Erfindung wird eine Rotorblattaktuatorstruktur bereitgestellt, bei der die oben beschriebenen beiden Ausführungsformen von Rotorblattaktuatoren bzw. Rotorblattaktuatoranordnungen derart kombiniert sind, dass bei benachbarten Rotorblattaktuatoren bzw. Rotorblattaktuatoranordnungen mit voneinander verschiedenen Verformungsarten eine Kollision einer Polbelegung Rotorblattaktuatoren bzw. Rotorblattaktuatoranordnungen durch Auswahl einer entsprechenden Ausführungsform vermieden werden kann, sodass keine separate Isolierung zwischen nicht korrespondierenden Polen notwendig ist.

Die einzelnen oben aufgeführten Merkmale können selbstverständlich auch untereinander kombiniert werden, wodurch sich zum Teil auch vorteilhafte Wirkungen einstellen können, die über die Summe der Einzelwirkungen hinausgehen.

Diese und andere Aspekte der vorliegenden Erfindung werden durch die Bezugnahme auf die hiernach beschriebenen beispielhaften Ausführungsformen erläutert und verdeutlicht.

### Kurze Beschreibung der Zeichnungen

Beispielhafte Ausführungsformen werden im Folgenden mit Bezugnahme auf die folgenden Zeichnungen beschrieben.
Figur 1 zeigt eine beispielhafte Ausführungsform eines Helikopters mit einem Rotor, der mit Rotorblättern versehen ist.
Figur 2 zeigt eine beispielhafte Ausführungsform eines einschichtigen Aktuators.
Figur 3 zeigt eine beispielhafte Ausführungsform eines zweischichtigen Aktuators mit zwei Längenänderungsrichtungen.
Figur 4 zeigt eine beispielhafte Ausführungsform eines Aktuators mit zwei aktiven Schichten und zwei passiven Schichten.
Figur 5 zeigt eine beispielhafte Ausführungsform eines zweischichtigen Aktuators mit zwei antiparallelen Längenänderungsrichtungen.
Figur 6 zeigt eine beispielhafte Ausführungsform eines zweischichtigen Aktuators mit zwei voneinander verschiedenen Längenänderungsrichtungen.
Figur 7 zeigt eine Anzahl möglicher Ausgestaltungen von Rotorblattaktuatoren bezüglich Kontaktierung, Umfangskontur und Aktuatorart.
Figuren 8a bis e zeigen unterschiedliche Ausführungsformen von Rotorblattaktuatoranordnungen mit unterschiedlichen Zusammensetzungen von Rotorblattaktuatoren.
Figuren 9a und 9b zeigen beispielhafte Ausfuhrungsformen eines sechseckigen Rotorblattaktuators mit unterschiedlichen Kontaktierungskonfigurationen.
Figur 10 zeigt eine beispielhafte Rotorblattaktuatorstruktur mit zwei aneinandergrenzenden Rotorblattaktuatoranordnungen, bei denen an den Grenzbereichen ein Kontaktierungskonflikt auftritt.
Figur 11 zeigt eine beispielhafte Ausführungsform einer Rotorblattaktuatorstruktur, bei der durch entsprechende Wahl der Ausführungsform der Rotorblattaktuatoren ein Kontaktierungskonflikt an Grenzbereichen der Rotorblattaktuatoranordnungen vermieden werden kann.
Figur 12 zeigt eine beispielhafte Ausführungsform einer Kontaktierungskonfiguration der in Figur 9b gezeigten Ausführungsform von Rotorblattaktuatoren.
Figur 13 zeigt eine Rotorblattaktuatorstruktur mit einer Mehrzahl von aneinandergrenzenden Rotorblattaktuatoranordnungen mit jeweils Rotorblattaktuatoren unterschiedlicher Betätigungsart.

### Detaillierte Beschreibung beispielhafter Ausführungsformen

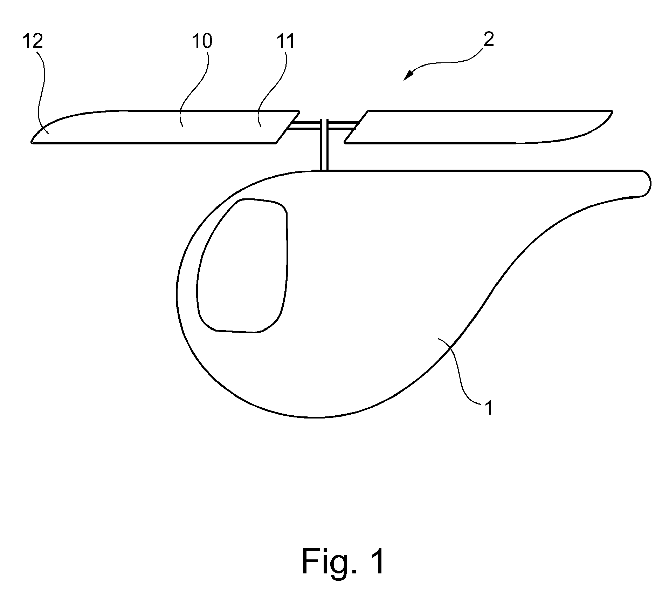

Figur 1 zeigt eine beispielhafte Ausführungsform eines Helikopters I mit einem Rotor 2, wobei der Rotor eine Mehrzahl von Rotorblättern 10 aufweist. Die Rotorblätter 10 sind jeweils am Bereich der Rotorblattwurzel 11 an einer Achse des Rotors 2 befestigt. Ferner weist jedes Rotorblatt 10 eine Rotorblattspitze 12 auf. Da die vorliegenden Erfindung eine Anordnung von Rotorblattaktuatoren bzw. Rotorblattaktuatoranordnungen auf einem Rotor betrifft, sind weitere Details des Helikopters 1 nicht im Detail dargestellt.

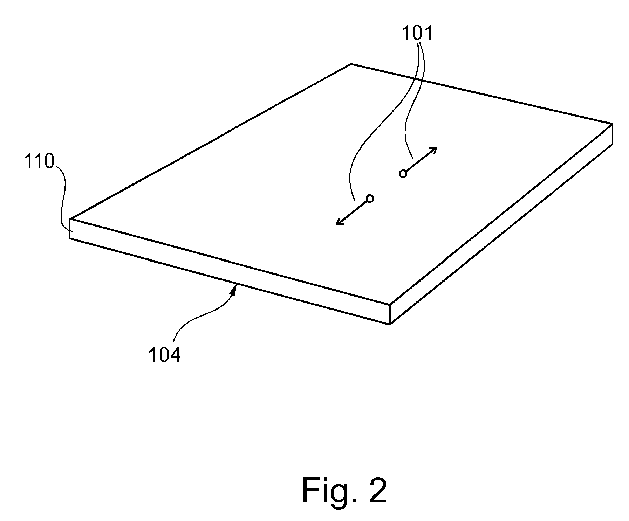

Figur 2 zeigt eine beispielhafte Ausführungsform eines Rotorblattaktuators 100 mit einer ersten aktiven Schicht 110. Die erste aktive Schicht 110 kann bei einer Betätigung des Rotorblattaktuators eine Längenänderung in eine erste Längenänderungsrichtung 101 vollziehen. Dies kann beispielsweise mit einer Piezoanordnung erfolgen, an die beispielsweise eine entsprechende Spannung angelegt wird, die den Aktuator bzw. die Aktuatorschicht zu einer Längenkontraktion oder Längenausdehnung bewegt. Der in Figur 2 gezeigte Rotorblattaktuator weist eine Aktuatoroberfläche 104 auf, die zur Applikation auf einem Rotorblatt bzw. einer Rotorblattdecke ausgestaltet ist. Dabei kann der Aktuator ungeachtet dessen, ob es sich um einen Aktuator mit einer einzigen aktiven Schicht oder zwei aktiven Schichten handelt, sowohl auf der Außenseite eines Rotorblattes als auch auf der Innenseite bzw. innerhalb eines Rotorblattes angeordnet sein. Unter der Innenseite eines Rotorblattes ist dabei der Bereich zu verstehen, der sich im Inneren des Rotorblattes befindet und somit vor äußeren Einflüssen geschützt ist. Die Aktuatoren können beispielsweise als Piezoaktuatoren ausgeführt sein. Vorzugsweise wird dabei der d33-Effekt in der ersten Richtung ausgenutzt. Die Aktuatoren können als sogenannte Stack-Aktuatoren oder mit interdigitalen Elektroden (interdigitated electrodes, IDE) ausgeführt sein.

Die Oberfläche 104 kann beispielsweise durch eine entsprechende Beschichtung oder Vorbehandlung derart ausgestaltet sein, dass sie leicht und ohne Fehleranfälligkeit auf dem Rotorblatt appliziert werden kann.

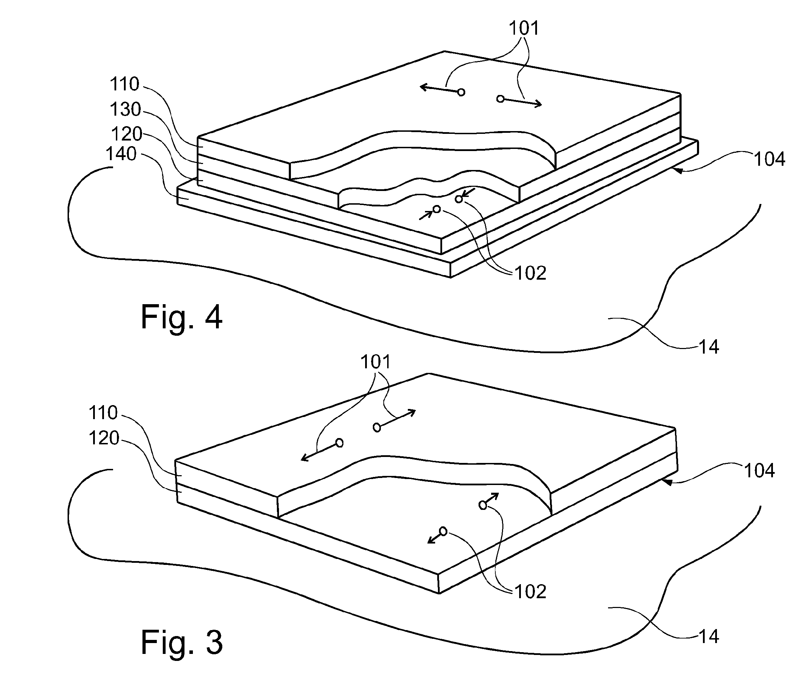

Figur 3 zeigt eine beispielhafte Ausführungsform eines Rotorblattaktuators mit zwei aktiven Schichten. Dabei sind die erste aktive Schicht 110 und die zweite aktive Schicht 120 übereinander angeordnet. Die erste aktive Schicht 110 weist eine erste Längenänderungsrichtung 101 auf, und die zweite aktive Schicht 120 weist eine zweite Längenänderungsrichtung 102 auf. In der hier gezeigten Ausführungsform ist die von der ersten aktiven Schicht abgewandte Seite der zweiten aktiven Schicht mit einer Oberfläche 104 versehen, die zur Applizierung auf einem Rotorblatt bzw. einer Rotorblattdecke geeignet ist. Die in Figur 3 gezeigte Ausführungsform zeigt die beiden Längenänderungsrichtungen 101, 102 in gleicher Richtung und in einer Parallelorientierung, wobei jedoch die Längenänderung unterschiedlich ist, so dass bei einer gleichförmigen Betätigung die erste aktive Schicht 110 eine größere Längenänderung vollzieht als die zweite aktive Schicht und sich somit ein Biegemoment an dem Aktuator einstellt. Auf diese Weise wird der Aktuator eine Biegung vollziehen und diese Biegung auf das Rotorblatt bzw. die Rotorblattdecke 14 derart übertragen, dass sich auch die Rotorblattdecke 14 verformt.

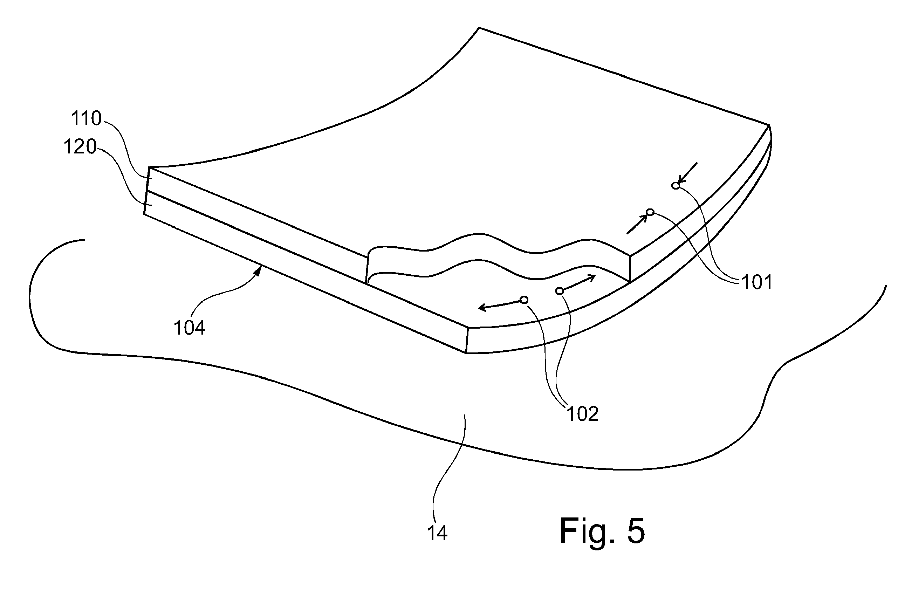

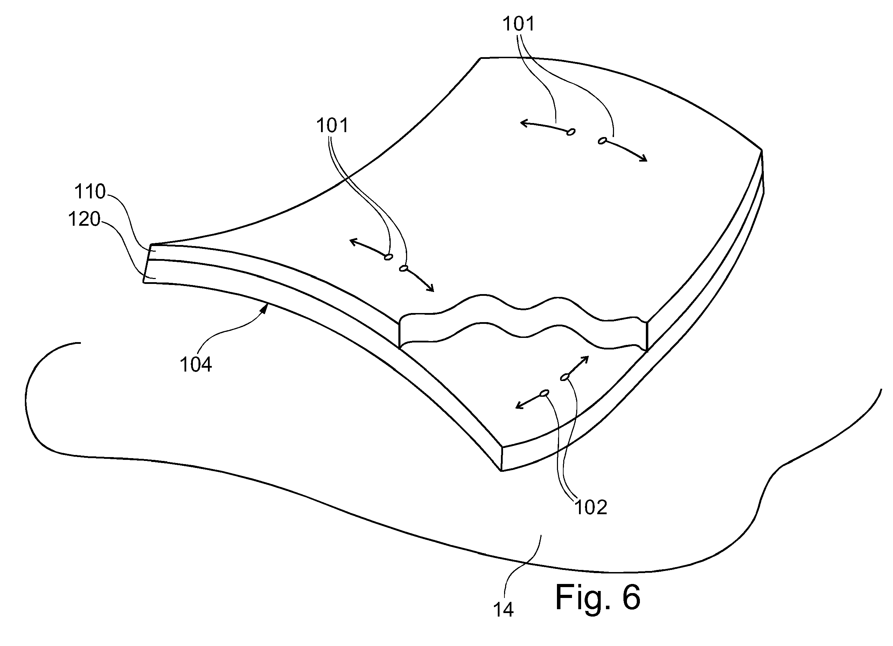

Figur 4 zeigt eine weitere beispielhafte Ausführungsform eines Rotorblattaktuators, wobei der in Figur 4 gezeigte Rotorblattaktuator eine erste und eine zweite aktive Schicht 110, 120 aufweist. Zwischen der ersten aktiven Schicht und der zweiten aktiven Schicht 110, 120 befindet sich hier eine passive dritte Schicht 130. Diese dritte Schicht kann beispielsweise als ein Substrat oder ein Träger dienen, auf den die beiden aktiven Schichten 110, 120 appliziert sind. Diese Trägerschicht kann beispielsweise aus einem glasfaserverstärkten Kunststoff oder einem kohlefaserverstärkten Kunststoff bestehen, um den gegebenenfalls empfindlichen Piezoaktuatoren die notwendige Stabilität zu verleihen, so dass diese gegenüber äußeren Einflüssen unempfindlich werden. Diese dritte Schicht kann zur Anordnung des Aktuators im Inneren des Blattes, zum Beispiel in der Symmetrieebene oder in der Profilsehne dienen. Neben der dritten Schicht kann auch eine passive vierte Schicht vorgesehen sein, die beispielsweise speziell für die Applizierung der Rotorblattaktuatorvorrichtung auf einem Rotorblatt ausgestaltet ist. In diesem Fall befindet sich die für die Applizierung auf dem Rotorblatt ausgestaltete Oberfläche 104 auf der Unterseite der passiven vierten Schicht 140. In der in Figur 4 gezeigten Ausführungsform sind die beiden Längenänderungsrichtungen 101, 102 verschieden voneinander, so dass der in Figur 4 gezeigte Rotorblattaktuator eine Schubverformung bzw. Torsionsverformung vollzieht. Es sei an dieser Stelle verstanden, dass die passive dritte Schicht sowie die passive vierte Schicht selbstverständlich auch bei einer Längenänderungsrichtung Anwendung finden kann, so wie sie in Figur 3 bzw. in Figur 5 und 6 beschrieben sind bzw. werden.

Die in Figur 5 gezeigte Ausführungsform zeigt eine zweischichtige Aktuatoranordnung mit zwei Längenänderungsrichtungen 101, 102, die jedoch antiparallel zueinander sind. Durch die antiparallele Anordnung der Längenänderungsrichtungen kann eine Verstärkung des Verbiegungsgrades erreicht werden, so dass eine stärkere Wölbung des Aktuators und damit der Rotorblattdecke 14 erfolgen kann.

Figur 6 zeigt eine beispielhafte Ausführungsform der Erfindung mit einer zweilagigen Aktuatoranordnung, wobei die Rotorblattaktuatoranordnung aus einer ersten aktiven Schicht 110 und einer zweiten aktiven Schicht 120 besteht. Die beiden aktiven Schichten 110, 120 weisen jeweils Längenänderungsrichtungen 101, 102 auf, die in der hier gezeigten Ausführungsform eine unterschiedliche Richtung derart aufweisen, dass sie zueinander geneigt sind, hier im rechten Winkel. Auf diese Weise erfährt der Rotorblattaktuator bei einer Betätigung sowohl der ersten aktiven Schicht 110 als auch der zweiten aktiven Schicht 120 eine Schubverformung bzw. tordierende Verformung, so dass sich eine Flächenform in Form eines Sattels ergibt. Durch die Applikation über die Applikationsoberfläche 104 auf die Rotorblattdecke wird auf diese Weise die Torsionskraft auf die Rotorblattdecke übertragen, so dass sich die Rotorblattdecke ebenfalls tordierend verformt. Die Längenänderung entlang der Längenänderungsrichtungen 101, 102 kann sowohl kontrahierend als auch expandierend sein, so dass sich unterschiedliche Sattelformen und Sattelkrümmungen ausbilden können.

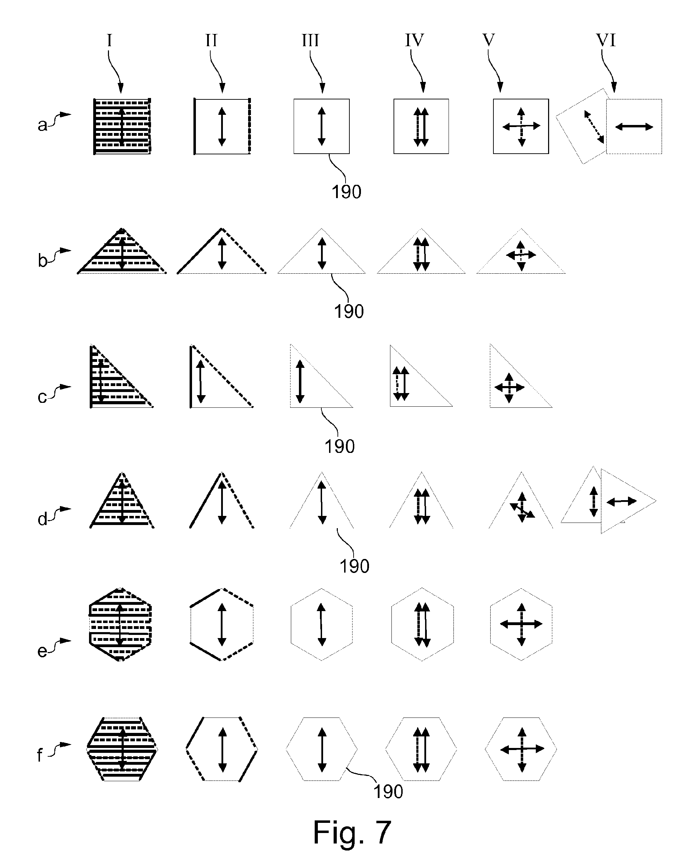

Figur 7 zeigt eine Vielzahl von möglichen Aktuatorformen bezüglich sowohl der Betätigungs- bzw. Verformungsrichtung als auch bezüglich der äußeren Kontur und der Kontaktierung. Es sind grundsätzlich die Aktuatorkonturformen in den Zeilen a, b, c, d, e, f denkbar kombiniert mit unterschiedlichen Konfigurationen in den Spalten I, II, III, IV, V, VI, wobei die Formen und Konfigurationen nicht auf die gezeigten beschränkt sind. Dabei sind beispielsweise eine quadratische oder rechteckige Aktuatorform a möglich für eine Kontaktierung für beispielsweise einen Piezoaktuator an gegenüberliegenden Kanten. Dabei stellt die durchgezogene fette Linie den ersten Kontaktpol und die gestrichelte Linie den zweiten Kontaktpol dar. Die Konfiguration I a ermöglicht eine Verformung bzw. eine Längenänderung in eine erste Richtung, wobei der Aktuator an seitlich gegenüberliegenden Flächen kontaktiert bzw. betätigt wird. Ein Aktuator kann dabei selbstverständlich auch rechteckig ausgestaltet sein. In der Spalte II sind die entsprechenden Aktuatoren dargestellt, jedoch mit der Außenkontaktierung eines ersten Kontaktpoles mit einer durchgezogenen Linie sowie eines zweiten Kontaktpoles in einer gestrichelten Linie. In der Spalte III ist eine erste Aktuatorausgestaltung eines einlagigen Aktuators dargestellt, der eine Verformungsrichtung bzw. eine Längenänderungsrichtung aufweist. Es sei angemerkt, dass die Pfeile auf den Aktuatoren die entsprechenden Längenänderungsrichtungen charakterisieren, d.h. ein einfacher Pfeil entspricht einem einlagigen Aktuator, während zwei Pfeile die beiden Längenänderungsrichtungen eines zweilagigen (d.h. zwei aktive Schichten) Aktuators darstellt. In der Spalte IV ist eine jeweilige Konfiguration eines Aktuators dargestellt, der als zweischichtiger Aktuator ausgeführt ist, wobei die erste Längenänderungsrichtung bzw. Verformungsrichtung parallel bzw. antiparallel zu der zweiten Verformungsrichtung bzw. Längenänderungsrichtung ist. In Spalte V ist eine jeweilige Konfiguration eines Aktuators dargestellt, bei der die beiden Verformungsrichtungen zueinander unterschiedlich sind, wobei die beiden Verformungsrichtungen nicht zwingend orthogonal zueinander liegen müssen. Ferner ist in Spalte VI eine Konfiguration dargestellt, bei der die beiden aktiven Schichten in einem beliebigen Winkel zueinander angeordnet sein können.

Bezüglich der äußeren Kontur sind neben der Konfiguration a auch eine Dreieckskonfiguration b möglich, bei der eine Kontaktierung eines hier gleichschenkligen Dreieckes über die beiden gleichen Schenkel erfolgt. Ferner ist auch eine Konfiguration c möglich, bei der die Kontaktierung zum einen über die Hypotenuse und zum anderen über eine Kathete eines rechtwinkligen Dreiecks erfolgt. In Konfiguration d ist ein gleichseitiges Dreieck vorgesehen, wobei die Kontaktierung über zwei der drei Seitenflächen erfolgt.

Ferner ist eine sechseckige Konfiguration in Form einer Wabe möglich. Eine Kontaktierung kann dabei zum einen in der Konfiguration e für den ersten Kontaktpol an einer ersten Seitenfläche und für den zweiten Kontaktpol an einer dazu benachbarten Seitenfläche erfolgen. Auf der jeweilig gegenüberliegenden Seitenfläche des Sechsecks befindet sich eine zweite Kontaktierungsfläche des jeweiligen gleichen Kontaktpols.

In der Konfiguration f befindet sich eine Kontaktfläche des ersten Kontaktpols auf einer ersten Seitenfläche sowie auf einer dieser gegenüberliegenden Seitenfläche und eines zweiten Kontaktpols auf einer zu der ersten Seitenfläche benachbarten Seitenfläche sowie einer dieser gegenüberliegenden Seitenfläche.

Auf diese Weise sind unterschiedliche Kontaktierungen und unterschiedliche Konfigurationsmuster möglich.

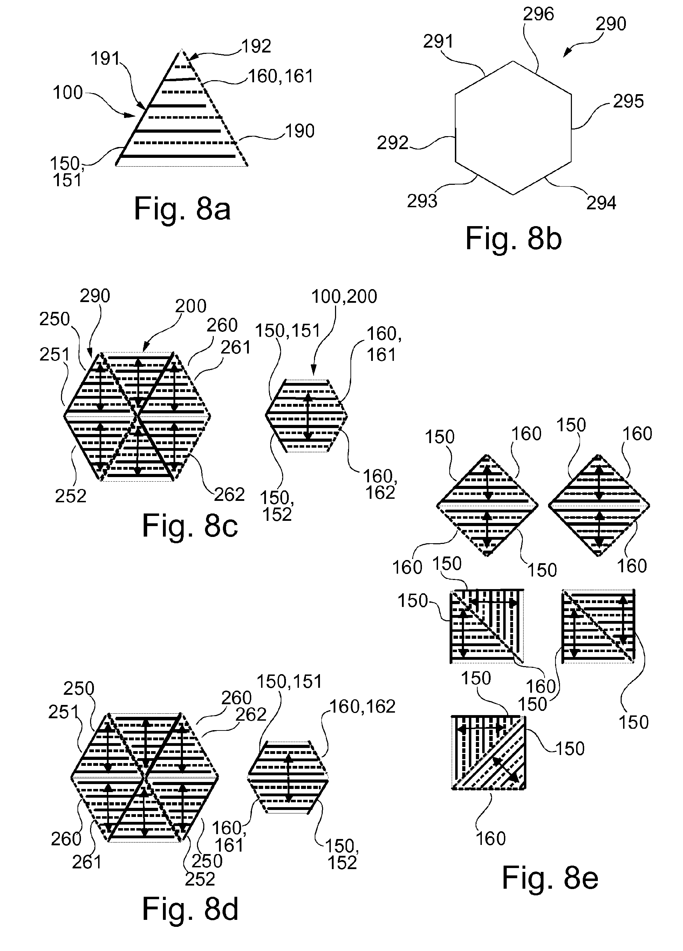

Figuren 8a, 8b, 8c, 8d und 8e zeigen unterschiedliche Aktuatoranordnungen mit Rotoraktuatoren. Der in Figur 8a gezeigte Rotorblattaktuator ist in Form einer Umfangskontur 190 eines gleichseitigen Dreiecks ausgeführt. Dabei ist auf einer ersten Seite 191 ein erster Kontaktpol 150 vorgesehen mit einer Kontaktfläche 151 sowie an einer zweiten Seitenfläche 192 ein zweiter Kontaktpol 160 mit einer Kontaktfläche 161. Über diese beiden Kontaktpole 150, 160 erfolgt die Ansteuerung an den Aktuator.

Aus einer Vielzahl der in Figur 8a gezeigten Rotorblattaktuatoren mit einer Umfangskontur 190 in Form eines gleichseitigen Dreiecks kann beispielsweise ein regelmäßiges Sechseck zusammengesetzt werden, so wie es in Figur 8b zu sehen ist. Das Sechseck, bestehend aus sechs gleichschenkligen Dreiecken kann dabei selbst als Aktuatoranordnung verstanden werden, zusammengesetzt aus einer Anzahl Einzelaktuatoren. Jedoch kann das zusammengesetzte Sechseck auch als resultierender Aktuator betrachtet werden, mit einer integeren Außengeometrie und einer resultierenden Verformung. Somit lässt sich ein derartiges Konstrukt sowohl als Aktuator als auch als Aktuatoranordnung m Sinne der vorliegenden Erfindung betrachten.

Die in Figur 8b gezeigte Rotoraktuatoranordnung weist eine Umfangskontur 290 in Form eines gleichseitigen Sechsecks auf mit einer ersten Seite 291, einer zweiten Seite 292, einer dritten Seite 293, einer vierten Seite 294, einer fünften Seite 295 sowie einer sechsten Seite 296. Dabei können die in Figur 8a gezeigten Rotorblattaktuatoren derart zusammengesetzt werden, dass korrespondierende Kontaktflächen 161, 151 derart korrespondierend aneinanderliegen, dass jeweils zueinandergehörige Pole miteinander kontaktiert sind.

In Figur 8c sind die jeweiligen Längenänderungsrichtungen mit Pfeilen eingezeichnet. Die zusammengesetzte Rotorblattaktuatoranordnung weist eine Umfangskontur 290 in Form eines gleichseitigen Sechsecks auf, wobei sich durch die zusammengesetzten gleichseitigen Dreiecke eine resultierende Kontaktkonfiguration ergibt, bei der ein erster Kontaktpol 250 an der ersten und zweiten Seite des gleichseitigen Sechsecks entsteht sowie ein zweiter Kontaktpol 260 an der vierten und fünften Seite des gleichseitigen Sechsecks. Der Kontaktpol 250 besteht dabei aus den beiden nach außen zeigenden Kontaktflächen 251 und 252 einerseits sowie aus den beiden Kontaktflächen 261, 260 andererseits für den zweiten Kontaktpol. Korrespondierend ergibt sich von außen betrachtet die in Figur 8c rechts dargestellte Aktuatorkonfiguration mit entsprechenden außenliegenden Kontaktflächen bzw. Kontaktpolen. Es sei dabei angemerkt, dass sich die in Figur 8c gezeigte Aktuatorkonfiguration aus zwei unterschiedlichen gleichseitigen Dreiecken zusammensetzt, wobei drei gleichseitige Dreiecke achsensymmetrisch gespiegelt gegenüber den anderen drei gleichseitigen Dreiecken sind, so dass sich die in Figur 8c gezeigte Aktuatorkonfiguration mit der dort auftretenden Kontaktkonfiguration ergibt.

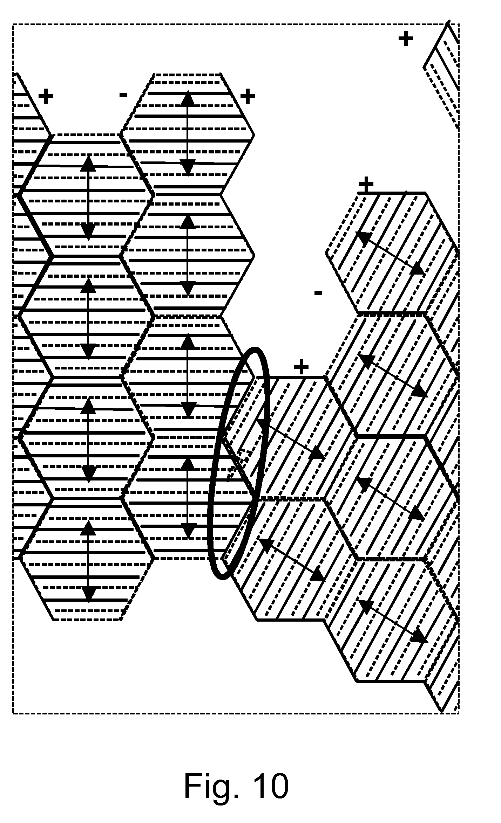

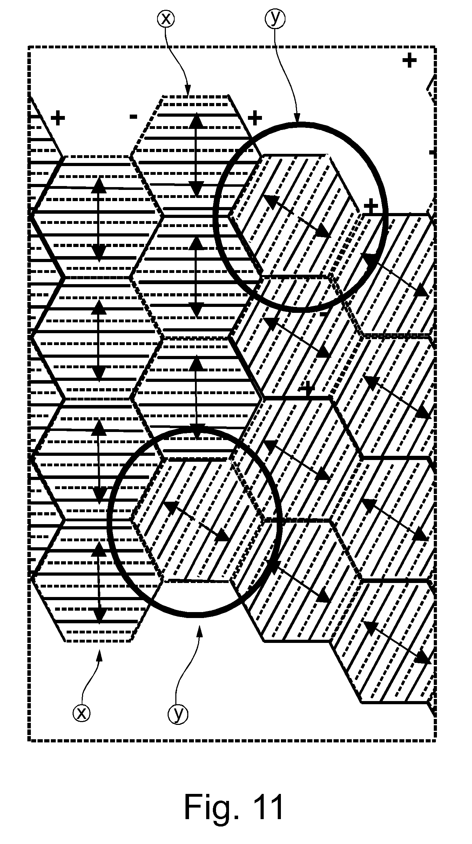

Analog ergibt sich aus der in Figur 8d gezeigten Anordnung eine Aktuatorkonfiguration mit einer anderen Kontaktkonfiguration. In der in Figur 8d gezeigten Aktuatoranordnung sind die erste und vierte Seite des gleichseitigen Dreiecks mit jeweils einer Kontaktfläche ausgestaltet, die zusammen einen ersten Kontaktpol darstellen, und die zweite und fünfte Fläche des gleichseitigen Sechsecks mit jeweils einer Kontaktfläche ausgestaltet, die zusammen einen zweiten Kontaktpol darstellen. Die in Figur 8d gezeigte Konfiguration setzt sich aus sechs gleichen Dreiecksaktuatoren zusammen. Die achsensymmetrischen Aktuatoren der Figur 8c können beispielsweise dadurch erreicht werden, dass die gleichen Aktuatoren einfach umgedreht werden (upside down) und mit der bisherigen von der Rotorblattoberfläche weggerichteten Oberseite auf der Rotorblattoberfläche appliziert werden. Im Wesentlichen reicht für einen derartigen Fall die Fertigung einer einzigen Art von Aktuatoren aus, nämlich die in Figur 8a gezeigte Konfiguration. Durch die unterschiedlichen Aktuatoranordnungen in der Figur 8c gegenüber der in Figur 8d gezeigten Aktuatoranordnung können bei einer flächigen Anordnung auf einer Rotorblattoberfläche die Rotorblattoberfläche flächendeckend ohne Lücken belegt werden und dabei unterschiedliche Bereiche aneinandergrenzen, ohne eine entsprechende Kontaktkonfliktsituation zu erhalten, wie später mit Bezugnahme auf die Figuren 10 und 11 noch beschrieben wird.

Figur 8e zeigt eine Zusammensetzung einer Aktuatoranordnung aus Rotorblattaktuatoren in Form eines gleichschenkligen Dreiecks, wodurch analog der in Figur 8a bis 8d beschriebenen Konfiguration unterschiedliche Rotorblattaktuatoranordnungen erstellt werden können unter Zurückgreifen auf eine einheitliche Grundform bzw. leichte Abwandlungen davon.

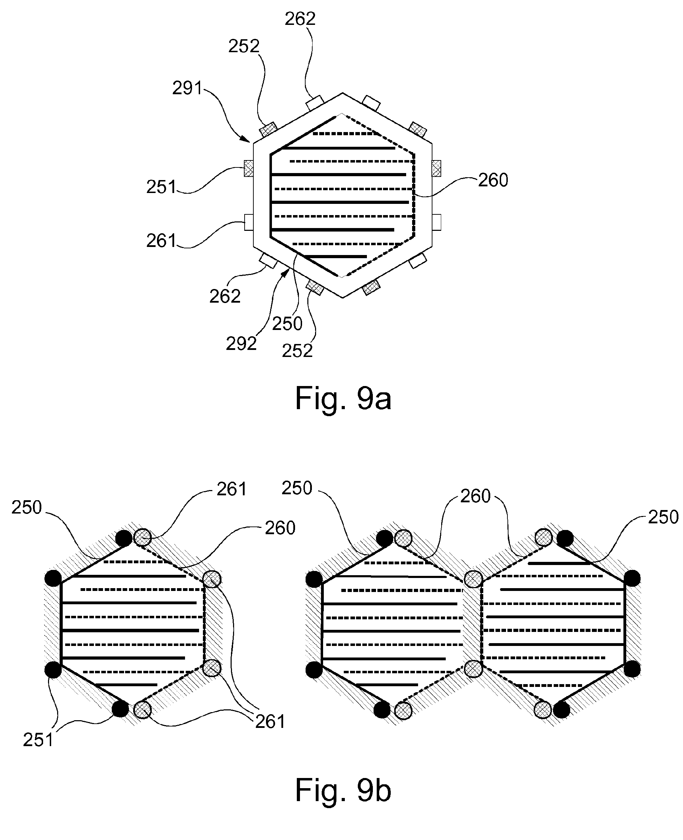

Figur 9a zeigt eine Rotorblattaktuatorvorrichtung gemäß einer weiteren Ausführungsform der Erfindung, bei der der Aktuator selbst mit einem ersten Kontaktpol 250 sowie einem zweiten Kontaktpol 260 versehen ist, wobei die entsprechenden Kontaktflächen 251, 252, 261, 262 jeweils paarweise an der Außenkante 291, 292 vorgesehen sind. Durch eine derartige Konfiguration können mehrere der in Figur 9a gezeigten Rotorblattaktuatoren flächendeckend aneinander gekoppelt werden und eine Durchkontaktierung erreicht werden, ohne dass jeder einzelne Rotorblattaktuator einzeln verdrahtet werden müsste. Eine derartige Ausführungsform kann beispielsweise eine interne Verdrahtung zwischen Kontaktpol 250 und entsprechenden Kontaktflächen 251, 252 sowie Kontaktpol 260 mit den zugehörigen Kontaktflächen 261, 262 aufweisen.

Figur 9b zeigt eine weitere Ausführungsform einer Kontaktierungsmöglichkeit, bei der entsprechende Kontaktpunkte an den jeweiligen Ecken des gleichseitigen Sechsecks ausgestaltet sind, so dass bei einer entsprechenden überlappenden Anordnung eine Durchkontaktierung zu dem benachbarten Rotorblattaktuator erfolgt. Die in Figur 9b gezeigte Anordnung dient somit nicht für ein aneinandergrenzendes bzw. aneinanderstoßendes Applizieren, sondern für ein überlappendes Applizieren auf der Rotorblattdecke. Es sei angemerkt, dass die bislang und im Folgenden beschriebenen Konfigurationen anhand einer sechseckigen Wabe ebenso für andere Polygonformen Anwendung finden können, beispielsweise in Form eines Quadrates oder eines gleichseitigen Fünfecks, jedoch hierauf nicht beschränkt sind. Insbesondere sind auch andere "Fliesenmuster" denkbar, die z.B. auf unterschiedliche Formen von Aktuatoren zurückgreifen, jedoch lückenlos zusammensetzbar sind.

Figur 10 zeigt eine detaillierte Ansicht einer Rotorblattaktuatorstruktur mit zwei aneinandergrenzenden Rotorblattaktuatoranordnungen. Eine Aktuatoranordnung ist dabei hier eine Anordnung gleichartiger Aktuatoren, die zu einer Form von Verformung führt. Bei zwei derartiger Anordnungen mit voneinander unterschiedlichen Verformungen bei einer Verwendung von nur einer Art von sechseckigen Rotorblattaktuatoren, beispielsweise der in Figur 8c gezeigten oder der in Figur 8d gezeigten Anordnung ergibt sich unweigerlich bei einer derartigen in Figur 10 gezeigten Konfiguration ein Kontaktkonflikt, der zu Kurzschlüssen verschiedener Rotorblattaktuatoren führen kann. Dies ergibt sich aus der Lage der Kontaktflächen bzw. der Kontaktpole an den entsprechenden Außenkanten des gleichseitigen Sechsecks. Eine derartige Kollision kann beispielsweise dadurch vermieden werden, dass eine entsprechende Isolationsschicht am aneinandergrenzenden Bereich vorgesehen wird. Jedoch können durch eine entsprechende Verwendung von Übergangsaktuatorelementen derartige Kontalakonflikte vermieden werden. Die kann auf die in Figur 11 gezeigte Art und Weise erfolgen. Die mit x bezeichneten Rotorblattaktuatoren entsprechen den in Figur 8c gezeigten Rotorblattaktuatoren, während die mit y bezeichneten Rotorblattaktuatoren denen in Figur 8d gezeigten Rotorblattaktuatoren entsprechen. Durch den Einsatz dieser in Figur 8d gezeigten Rotorblattaktuatoren kann ein entsprechender Konflikt bei der Kontaktierung vermieden werden, da die eigentlichen Kontaktflächen so angeordnet sind, dass sie mit den entsprechenden Rotorblattaktuatoren der benachbarten Rotorblattaktuatoranordnung korrespondieren und nicht in einem Konflikt stehen.

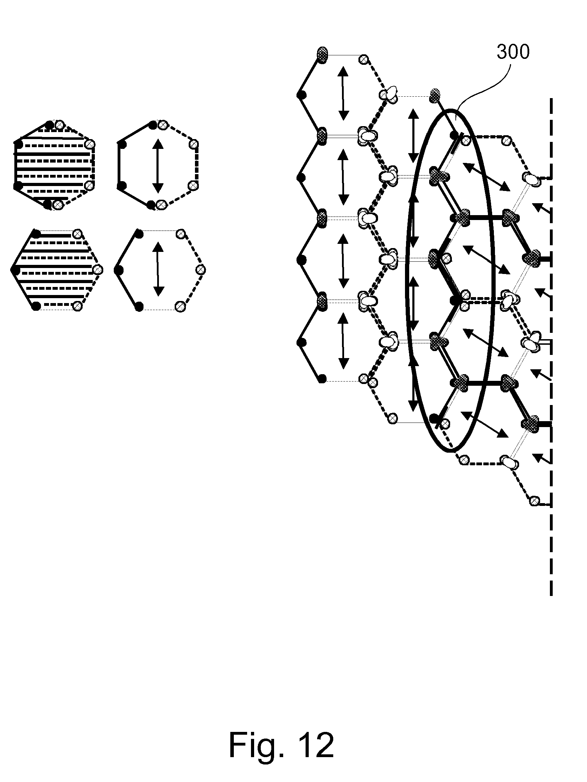

Eine ähnliche Konfiguration ist in Figur 12 dargestellt, bei der die in Figur 9b gezeigten Rotorblattaktuatoren in zwei Rotorblattaktuatoranordnungen aneinanderstoßen, dort jedoch durch entsprechende Isolationsstücke getrennt sind. Somit wird die Kontaktgrenze im Grenzbereich 300 durch eine entsprechende Isolationsbarriere hergestellt.

Insbesondere ist es mit den beschriebenen Aktuatoren und Aktuatoranordnungen möglich durch entsprechende Verdrehung der Richtung der aktiven Dehnung der Rotorblattaktuatoren in benachbarten Bereichen (A, B+C, D in Figur 1) unterschiedliche Blattverformung wie Biegung (Bereich D spannweitig oder Bereich A in Tiefenrichtung), Torsion und Wölbung (in den Bereichen B, C) auf einfache Art mittels automatischer Kontaktierung der Aussenelektroden ohne zusätzliche Leiterbahnen zu realisieren.

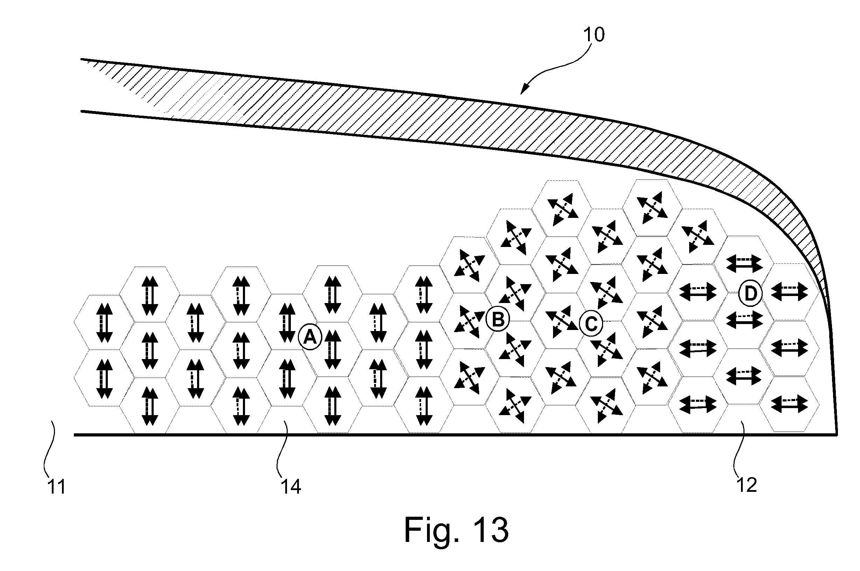

Figur 13 zeigt eine beispielhafte Anordnung unterschiedlicher Aktuatoranordnungen A, B, C und D. Die im Bereich A gezeigten Aktuatoren weisen eine erste Verformungs- bzw. Biegerichtung in eine Richtung auf, und zwar in azimutaler Richtung. Anordnung A befindet sich in Richtung der Blattwurzel 11 auf dem Rotorblatt bzw. der Rotorblattdecke 14. Die im Bereich D gezeigten Rotorblattaktuatoren bzw. der Rotorblattaktuatoranordnung weist eine Verbiegungsrichtung in radialer Richtung auf, so dass eine vertikale Bewegung der Blattspitze 12 erreicht werden kann. Die im Bereich B und C angeordneten Rotorblattaktuatoren bzw. der Rotorblattaktuatoranordnung weist Rotorblattaktuatoren auf, die eine tordierende Verformung hervorrufen. Auf diese Weise kann ein Übergang zwischen der in Azimutalrichtung verbiegenden Aktuatoren und der in Radialrichtung verbiegenden Aktuatoren im Bereich D hergestellt werden. Die entsprechenden Grenzbereiche zwischen den Bereichen A und B einerseits sowie D und C andererseits wird analog der Konfiguration vorgenommen, wie sie mit Bezugnahme auf die Figuren 10, 11 und 12 beschrieben sind.

## Patentansprüche

1. Rotorblatt (10) mit einem Rotorblattaktuator (100) mit
einer Aktuatoroberfläche (104), die auf einer Oberfläche des Rotorblattes bzw. der Rotorblattspitze appliziert ist,
einer ansteuerbaren aktiven ersten Schicht (110), die parallel zu der Aktuatoroberfläche angeordnet ist,
wobei die erste Schicht eine Ansteuerbarkeit aufweist, die bei einer Ansteuerung eine Längenänderung in eine erste Richtung (101) entlang der Aktuatoroberfläche hervorruft,
wobei der Rotorblattaktuator (100) durch die Längenänderung eine Verformung der Oberfläche des Rotorblattes bzw. der Rotorblattspitze hervorruft;
**dadurch gekennzeichnet, dass** die Umfangskontour des Rotorblattaktuators (100) einem gleichmäßigen Sechseck oder einer Gleichteilung davon entspricht.

2. Rotorblatt nach Anspruch 1, wobei der Rotorblattaktuator ferner mit einer über der ansteuerbaren ersten Schicht (110) angeordneten ansteuerbaren aktiven zweiten Schicht (120),
wobei die zweite Schicht eine Ansteuerbarkeit aufweist, die bei einer Ansteuerung eine Längenänderung in eine zweite Richtung (102) entlang der Aktuatoroberfläche (104) hervorruft,
wobei die erste Schicht und die zweite Schicht derart miteinander gekoppelt sind, dass der Rotorblattaktuator (100) bei einer Längenänderung in eine erste Richtung (101) und eine davon verschiedene Längenänderung in eine zweite Richtung (102) eine veränderte Krümmung der Aktuatoroberfläche aufweist.

3. Rotorblatt nach Anspruch 2, wobei die erste Richtung (101) und die zweite Richtung (102) voneinander verschieden sind.

4. Rotorblatt nach einem der Ansprüche 2 oder 3, wobei die erste Richtung (101) und die zweite Richtung (102) antiparallel zueinander sind.

5. Rotorblatt nach einem der Ansprüche 2 bis 4, wobei die erste Richtung (101) und die zweite Richtung (102) senkrecht zueinander sind.

6. Rotorblatt nach einem der Ansprüche 1 bis 5, wobei der Rotorblattaktuator (100) eine Umfangskontur (190) bezogen auf seine flächige Ausgestaltung aufweist, die im Wesentlichen einem gleichseitigen Dreieck entspricht.

7. Rotorblatt nach Anspruch 6, wobei der Rotorblattaktuator (100) eine zweipolige Kontaktierung mit einem ersten Kontaktpol (150) und einem zweiten Kontaktpol (160) aufweist, wobei der erste Kontaktpol (150) eine Kontaktfläche (151) an einer ersten Seite (191) des Dreiecks aufweist und der zweite Kontaktpol (160) eine Kontaktfläche (161) an einer zu der ersten Seite benachbarten zweiten Seite (192) des Dreiecks aufweist.

8. Rotorblattaktuatoranordnung mit einem Rotorblatt nach einem der Ansprüche 1 bis 7, wobei der Rotorblattaktuator (100) eine Umfangskontur (190) bezogen auf seine flächige Ausgestaltung aufweist, die im Wesentlichen einem regelmäßigen Polygon entspricht.

9. Rotorblattaktuatoranordnung nach Anspruch 8, wobei die Rotorblattaktuatoranordnung (200) eine Umfangskontur (290) bezogen auf eine flächige Ausgestaltung der Rotorblattaktuatoranordnung aufweist, die im Wesentlichen einem gleichseitigen Sechseck entspricht.

10. Rotorblattaktuatoranordnung nach einem der Ansprüche 8 oder 9, wobei die Rotorblattaktuatoranordnung (200) sechs Rotorblattaktuatoren (100) eines Rotorblatts nach einem der Ansprüche 1 bis 7 aufweist.

11. Rotorblattaktuatoranordnung nach einem der Ansprüche 9 oder 10, wobei die Rotorblattaktuatoranordnung (200) eine zweipolige Kontaktierung mit einem ersten Kontaktpol (250) und einem zweiten Kontaktpol (260) aufweist, wobei der erste Kontaktpol (250) jeweils eine Kontaktfläche (251, 252) an einer ersten Seite (291) und an einer der ersten Seite benachbarten zweiten Seite (292) des Sechsecks aufweist und der zweite Kontaktpol (260) jeweils eine Kontaktfläche (261, 262) an einer der ersten Seite gegenüberliegenden vierten Seite (294) und an einer der zweiten Seite gegenüberliegenden fünften Seite (295) des Sechsecks aufweist.

12. Rotorblattaktuatoranordnung nach einem der Ansprüche 9 oder 10, wobei der Rotorblattaktuatoranordnung (200) eine zweipolige Kontaktierung mit einem ersten Kontaktpol (250) und einem zweiten Kontaktpol (260) aufweist, wobei der erste Kontaktpol jeweils eine Kontaktfläche (251, 252) an einer ersten Seite (291) und an einer der ersten Seite gegenüberliegenden vierten Seite (294) des Sechsecks aufweist und der zweite Kontaktpol (260) jeweils eine Kontaktfläche (261, 262) an einer der ersten Seite benachbarten zweiten Seite (292) und an einer der zweiten Seite gegenüberliegenden fünften Seite (295) des Sechsecks aufweist.

13. Rotorblattaktuatoranordnung nach einem der Ansprüche 8 bis 10, wobei die Rotorblattaktuatoranordnung eine zweipolige Kontaktierung mit einem ersten Kontaktpol (250) und einem zweiten Kontaktpol (260) aufweist, wobei sowohl der erste Kontaktpol als auch der zweite Kontaktpol jeweils eine Kontaktfläche (251, 261; 252, 262) an wenigstens einer ersten Seite (291) und einer zweiten Seite (292) des gleichmäßigen Polygons aufweisen und die Kontaktfläche (251) des ersten Kontaktpols und die Kontaktfläche (252) des zweiten Kontaktpols an der ersten Seite (291) derart angeordnet sind, dass sie bezüglich eine Position und Polarität mit der Kontaktfläche (252) des ersten Kontaktpols (250) und der Kontaktfläche (262) des zweiten Kontaktpols (260) an der zweiten Seite (292) derart korrespondieren, dass bei einem benachbarten Positionieren der ersten Seite und einer zweiten Seite einer benachbarten Rotoraktuatoranordnung eine benachbarte Position korrespondierender Kontaktflächen erreicht wird.

14. Rotorblattaktuatoranordnung nach einem der Ansprüche 11 bis 13, wobei die Kontaktflächen (251, 252, 261, 262) an einer bezüglich der Umfangskontur (290) nach außen gerichteten Kante angeordnet sind.

15. Rotorblattaktuatorstruktur mit einem Rotorblatt (10) gemäß einem der Ansprüche 1 bis 7, aufweisend eine Vielzahl von Rotorblattaktuatoren (100), wobei die Vielzahl von Rotorblattaktuatoren in einer Rotorblattaktuatoranordnung (200) nach einem der Ansprüche 8 bis 14 in einer Wabenstruktur angeordnet sind.

16. Rotorblattaktuatorstruktur nach Anspruch 15, wobei benachbarte Rotorblattaktuatoranordnungen (200) Rotorblattaktuatoranordnungen nach einem der Ansprüche 11 oder 14 sind, wobei benachbarte Rotorblattaktuatoranordnungen (200) mit voneinander verschiedenen Verformungsarten bei Kollision einer Polbelegung Rotorblattaktuatoranordnungen (200) nach einem der Ansprüche 12 oder 14 sind.

## Claims

1. A rotor blade (10) having a rotor blade actuator (100) with an actuator surface (104) which is applied on a surface of the rotor blade respectively the rotor blade tip,
a controllable active first layer (110), arranged parallel to the actuating surface,
wherein the first layer has a controllability, which during control causes an elongation in a first direction (101) along the actuating surface,
wherein the rotor blade actuator (100) by the elongation can cause a deformation of the surface of the rotor blade respectively the rotor blade tip;
**characterized in that** the contour of the rotor blade actuator (100) corresponds to a uniform hexagon or an equal division of it.

2. The rotor blade according to claim 1, wherein the rotor blade actuator is further arranged with a controllable active second layer (120) over the controllable first layer (110),
wherein the second layer has a controllability for causing an elongation in a second direction (102) along the actuating surface (104),
wherein the first layer and the second layer are coupled in a way that the rotor blade actuator (100) during an elongation in a first direction (101) and a different elongation in a second direction (102) causes a changing curvature of the actuator surface.

3. The rotor blade according to claim 2, wherein the first direction (101) and the second direction (102) are different from each other.

4. The rotor blade according to one of the claims 2 or 3, wherein the first direction (101) and the second direction (102) are anti-parallel to each other.

5. The rotor blade according to one of the claims 2 to 4, wherein the first direction (101) and the second direction (102) are perpendicular to each other.

6. The rotor blade according to one of the claims 1 to 5, wherein the rotor blade actuator (100) has, based on its two-dimensional configuration, a circumferential contour (190) which essentially corresponds to an equilateral triangle.

7. The rotor blade according to claim 6, wherein the rotor blade actuator (100) having a two pole contact with a first contact pole (150) and a second contact pole (160), said first contact pole (150) having a contact surface (151) on a first side (191) of the triangle and the second contact pole (160) having a contact surface (161) on a second side (192) adjacent to the first side of the triangle.

8. A rotor blade actuator arrangement with a rotor blade according to one of the claims 1 to 7, wherein the rotor blade actuator (100) has a circumferential contour (190) based on its planar configuration that is substantially equivalent to a regular polygon.

9. The rotor blade actuator arrangement according to claim 8, wherein the rotor blade actuator arrangement (200) has a circumferential contour (290) based on a planar configuration of the rotor blade actuator arrangement that substantially corresponds to an equilateral hexagon.

10. The rotor blade actuator arrangement according to one of claims 8 or 9, wherein the rotor blade actuator arrangement (200) comprises six rotor blade actuators (100) of a rotor blade according to one of claims 1 to 7.

11. The rotor blade actuator arrangement according to one of claims 9 or 10, wherein the rotor blade actuator arrangement (200) having a two-pole contacting with a first contact pole (250) and a second contact pole (260), wherein the first contact pole (250) having each a contact surface (251, 252) on a first side (291) and to the first side adjacent second side (292) of the hexagon and the second contact point (260) each having a contact surface (261, 262) to the first side opposite fourth side (294) and to the second side opposite fifth side (295) of the hexagon.

12. The rotor blade actuator arrangement according to one of claims 9 or 10, wherein the rotor blade actuator arrangement (200) having a two-pole contacting with a first contact pole (250) and a second contact pole (260), wherein the first contact pole each have a contact surface (251, 252) on a first side (291) and on a to the first side opposite fourth side (294) of the hexagon and the second contact point (260) each having a contact surface (261, 262) on one of the first side adjacent second side (292) and on a to a second side opposite fifth side (295) of the hexagon.

13. The rotor blade actuator arrangement according to one of claims 8 to 10, wherein the rotor blade actuator arrangement having a two pole contacting with a first contact pole (250) and a second contact pole (260), wherein both the first contact pole and the second contact pole in each case having a contact surface (251, 261; 252, 262) to at least a first side (291) and a second side (292) of the uniform polygon and the contact surface (251) of the first contact pole and the contact surface (252) of the second contact pole (291) are arranged to the first side such that they correspond in position and polarity with respect to a contact surface (252) of the first contact (250) and the contact surface (262) of the second contact point (260) on the second side (292), such that at an adjacent positioning of the first side and the second side of an adjacent rotor blade actuator arrangement an adjacent position corresponding contact surfaces is achieved.

14. The rotor blade actuator arrangement according to one of claims 11 to 13, wherein the contact surfaces (251, 252, 261, 262) are arranged at a relative to the circumferential contour (290) outwardly directed edge.

15. A rotor blade actuator structure with a rotor blade (10) according to any one of claims 1 to 7, comprising a plurality of rotor blade actuators (100) wherein the plurality of rotor blade actuators in a rotor blade actuator arrangement are arranged in a honeycomb structure (200) according to any of claims 8 to 14.

16. The rotor blade actuator structure according to claim 15, wherein adjacent rotor blade actuator arrangements (200) are rotor blade actuator arrangements according to claims 11 or 14, wherein adjacent rotor blade actuator arrangements (200) having different types of deformation at collision of a pole assignment are rotor blade actuator arrangements (200) according to one of claims 12 or 14.

## Revendications

1. Pale de rotor (10) comportant un actionneur de pale de rotor (100) comportant :
une surface d'actionneur (104), qui est appliquée sur une surface de la pale de rotor, respectivement de l'extrémité de la pale de rotor,
une première couche (110) active actionnable, qui est disposée parallèle à la surface d'actionneur,
dans laquelle la première couche présente une capacité d'actionnement qui, lors d'un actionnement, entraîne une modification de la longueur dans une première direction (101) le long de la surface d'actionneur,
dans laquelle l'actionneur de pale de rotor (100) entraîne, par la modification de la longueur, une déformation de la surface de la pale de rotor, respectivement de l'extrémité de la pale de rotor,
**caractérisée en ce que** le contour périphérique de l'actionneur de pale de rotor (100) correspond à un hexagone régulier ou à une division à parts égales de ce dernier.

2. Pale de rotor selon la revendication 1, dans laquelle l'actionneur de pale de rotor comporte en outre :
une seconde couche (120) active actionnable disposée au-dessus de la première couche (110) actionnable,
dans laquelle la seconde couche présente une capacité d'actionnement qui, lors d'un actionnement, entraîne une modification de la longueur dans une seconde direction (102) le long de la surface d'actionneur (104),
dans laquelle la première couche et la seconde couche sont couplées l'une à l'autre de telle manière que l'actionneur de pale de rotor (100) présente une courbure modifiée de la surface d'actionneur lors d'une modification de longueur dans une première direction (101) et d'une modification de longueur différente de celle-ci dans une seconde direction (102).

3. Pale de rotor selon la revendication 2, dans laquelle la première direction (101) et la seconde direction (102) diffèrent l'une de l'autre.

4. Pale de rotor selon l'une des revendications 2 ou 3, dans laquelle la première direction (101) et la seconde direction (102) sont antiparallèles l'une à l'autre.

5. Pale de rotor selon l'une des revendications 2 à 4, dans laquelle la première direction (101) et la seconde direction (102) sont perpendiculaires l'une à l'autre.

6. Pale de rotor selon l'une des revendications 1 à 5, dans laquelle l'actionneur de pale de rotor (100) comporte un contour périphérique (190) par rapport à sa configuration plane, qui correspond sensiblement à un triangle équilatéral.

7. Pale de rotor selon la revendication 6, dans laquelle l'actionneur de pale de rotor (100) comporte une mise en contact à deux pôles avec un premier pôle de contact (150) et un second pôle de contact (160), le premier pôle de contact (150) comportant une surface de contact (151) sur un premier côté (191) du triangle et le second pôle de contact (160) comportant une surface de contact (161) sur un deuxième côté (192) du triangle adjacent au premier côté.

8. Agencement d'actionneurs de pale de rotor comprenant une pale de rotor selon l'une des revendications 1 à 7, dans lequel l'actionneur de pale de rotor (100) comporte un contour périphérique (190) par rapport à sa configuration plane, qui correspond sensiblement à un polygone régulier.

9. Agencement d'actionneurs de pale de rotor selon la revendication 8, dans lequel l'agencement d'actionneurs de pale de rotor (200) comporte un contour périphérique (290) par rapport à une configuration plane de l'agencement d'actionneurs de pale de rotor, qui correspond sensiblement à un hexagone équilatéral.

10. Agencement d'actionneurs de pale de rotor selon l'une des revendications 8 ou 9, dans lequel l'agencement d'actionneurs de pale de rotor (200) comporte six actionneurs de pale de rotor (100) d'une pale de rotor selon l'une des revendications 1 à 7.

11. Agencement d'actionneurs de pale de rotor selon l'une des revendications 9 ou 10, lequel agencement d'actionneurs de pale de rotor (200) comportant une mise en contact à deux pôles avec un premier pôle de contact (250) et un second pôle de contact (260), le premier pôle de contact (250) comportant respectivement une surface de contact (251, 252) sur un premier côté (291) et sur un deuxième côté (292) de l'hexagone adjacent au premier côté et le second pôle de contact (260) comportant respectivement une surface de contact (261, 262) sur un quatrième côté (294) de l'hexagone opposé au premier côté et sur un cinquième côté (295) de l'hexagone opposé au deuxième côté.

12. Agencement d'actionneurs de pale de rotor selon l'une des revendications 9 ou 10, lequel agencement d'actionneurs de pale de rotor (200) comportant une mise en contact à deux pôles avec un premier pôle de contact (250) et un second pôle de contact (260), le premier pôle de contact (250) comportant respectivement une surface de contact (251, 252) sur un premier côté (291) et sur un quatrième côté (294) de l'hexagone opposé au premier côté et le second pôle de contact (260) comportant respectivement une surface de contact (261, 262) sur un deuxième côté (292) de l'hexagone adjacent au premier côté et sur un cinquième côté (295) de l'hexagone opposé au deuxième côté.

13. Agencement d'actionneurs de pale de rotor selon l'une des revendications 8 à 10, lequel agencement d'actionneurs de pale de rotor comportant une mise en contact à deux pôles avec un premier pôle de contact (250) et un second pôle de contact (260), aussi bien le premier pôle de contact que le second pôle de contact comportant respectivement une surface de contact (251, 261 ; 252, 262) sur au moins un premier côté (291) et un deuxième côté (292) du polygone régulier et la surface de contact (251) du premier pôle de contact et la surface de contact (252) du second pôle de contact étant disposées de telle manière sur le premier côté (291) qu'elles correspondant, en ce qui concerne une position et une polarité, à la surface de contact (252) du premier pôle de contact (250) et la surface de contact (262) du second pôle de contact (260) sur le deuxième côté (292) de telle manière que lors d'un positionnement adjacent du premier côté et d'un deuxième côté d'un agencement d'actionneurs de pale de rotor adjacent, une position adjacente de surfaces de contact correspondantes est obtenue.

14. Agencement d'actionneurs de pale de rotor selon l'une des revendications 11 à 13, dans lequel les surfaces de contact (251, 252, 261, 262) sont disposées sur une arête orientée vers l'extérieur par rapport à un contour périphérique (290).

15. Structure d'actionneurs de pale de rotor comprenant une pale de rotor (10) selon l'une des revendications 1 à 7, comportant une pluralité d'actionneurs de pale de rotor (100), la pluralité d'actionneurs de pale de rotor étant disposée dans un agencement d'actionneurs de pale de rotor (200) selon l'une des revendications 8 à 14 en une structure alvéolée.

16. Structure d'actionneurs de pale de rotor selon la revendication 15, lequel des agencements d'actionneurs de pale de rotor (200) adjacents sont des agencements d'actionneurs de pale de rotor selon l'une des revendications 11 ou 14, des agencements d'actionneurs de pale de rotor (200) adjacents avec des types de déformation différents les uns des autres étant des agencements d'actionneurs de pale de rotor (200) selon l'une des revendications 12 ou 14 lors d'un conflit d'une affectation de pôle.
